(19) Europäisches Patentamt
European Patent Office
Office européen des brevets

(11) **EP 2 645 382 B1**

(12) **EUROPEAN PATENT SPECIFICATION**

(45) Date of publication and mention
of the grant of the patent:
**11.03.2020 Bulletin 2020/11**

(51) Int Cl.:
*H01F 6/06* (2006.01)    *H01R 4/68* (2006.01)
*G01R 33/38* (2006.01)    *G01R 33/3815* (2006.01)
*H01R 4/02* (2006.01)

(21) Application number: **11843453.9**

(22) Date of filing: **22.11.2011**

(86) International application number:
**PCT/JP2011/076941**

(87) International publication number:
**WO 2012/070584 (31.05.2012 Gazette 2012/22)**

(54) **OXIDE SUPERCONDUCTIVE SOLENOID WOUND COIL AND PRODUCTION METHOD THEREFOR**

WINDUNGSSPULE MIT EINEM OXIDSUPRALEITER-MAGNETEN UND
HERSTELLUNGSVERFAHREN DAFÜR

BOBINE ENROULÉE À SOLÉNOÏDE À SUPRACONDUCTEUR OXYDE ET PROCÉDÉ DE
FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.11.2010 JP 2010260439**

(43) Date of publication of application:
**02.10.2013 Bulletin 2013/40**

(73) Proprietors:
• **Kabushiki Kaisha Kobe Seiko Sho
(Kobe Steel, Ltd.)
Kobe-shi, Hyogo 6518585 (JP)**
• **National Institute for Materials Science
Tsukuba-shi, Ibaraki 305-0047 (JP)**

(72) Inventors:
• **HASE, Takashi
Kobe-shi, Hyogo 651-2271 (JP)**
• **HAMADA, Mamoru
Kobe-shi, Hyogo 651-2271 (JP)**
• **KIYOSHI, Tsukasa
Ibaraki 305-0047 (JP)**

(74) Representative: **Müller-Boré & Partner
Patentanwälte PartG mbB
Friedenheimer Brücke 21
80639 München (DE)**

(56) References cited:
EP-A1- 1 158 543     JP-A- 2000 133 067
JP-A- 2000 133 067    JP-A- 2001 307 915
JP-A- 2007 266 149    JP-A- 2007 266 149
JP-A- 2009 043 759    JP-A- 2009 043 759
JP-A- 2009 117 202    US-A- 3 458 842

**Description**

TECHNICAL FIELD

The present invention relates to oxide superconducting solenoid wound coils each including plural tape-shaped oxide superconducting wires connected and helically wound in multilayers (in solenoid form); and methods for producing the same. More particularly, the present invention relates to the structure of oxide superconducting solenoid wound coils required to have high magnetic field homogeneity as in superconducting magnets to be used for nuclear magnetic resonance (NMR) spectrometers; and useful methods for producing such oxide superconducting solenoid wound coils.

BACKGROUND ART

As superconducting wires, there have been known metal-based superconducting wires such as those made of NbTi or $Nb_3Sn$, and oxide-based superconducting wires such as those made of Bi-based oxides or Y-based oxides. The former metal-based superconducting wires are in the form of a band (belt) having a round or flat square (rectangular) cross-sectional shape and a certain degree of thickness. The latter oxide-based superconducting wires are needed to adjust the orientation of oxide crystals by rolling or the like, and therefore, those having a thin tape shape are prevailing.

Among the superconducting wires, the oxide-based superconducting wires have short lengths in the case of single wires, and therefore, it is difficult to wind a single wire into a large coil without forming a connecting portion in the course of the winding.

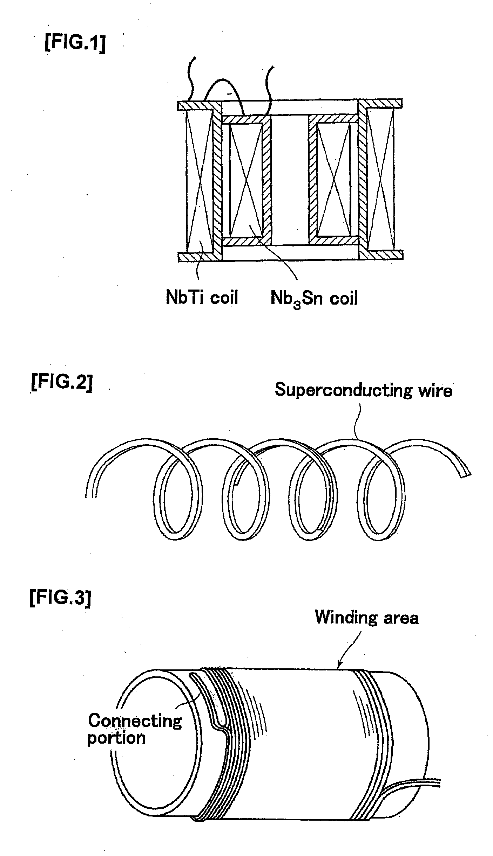

For connection between metal-based superconducting wire coils, there has widely been used a method in which a coil of an NbTi metal-based superconducting wire (NbTi coil) and a coil of an $Nb_3Sn$ metal-based superconducting wire ($Nb_3Sn$ coil) are separately produced and then combined as shown in Fig. 1. In such a connection, however, an ineffective space is caused from the outer periphery of the winding area (superconducting wire wound area) of the inner $Nb_3Sn$ coil to the inner periphery of the winding area of the outer NbTi coil. For this reason, more wires have to be used to generate the same magnetic field, as compared with the case of close winding as a single coil. In addition, two spools have to be used, and therefore, it causes a problem that the production cost becomes increased. Furthermore, two coils have to be combined, and therefore, the relative positions of the NbTi coil and the $Nb_3Sn$ coil may easily be displaced by the electromagnetic force generated in these coils, and when such a displacement suddenly occurs, these coils are more likely to cause quench.

To solve such problems, for example, there is proposed in Patent Document 1, a technique of forming a composite coil with a single spool by forming a fiber-reinforced plastic (FRP) surface including fibers to serve as an insulation coating layer on the outer periphery of an $Nb_3Sn$ metal-based superconducting wire and then winding an NbTi superconducting wire around the surface.

When metal-based superconducting wires are connected together within the winding area as in the technique described above, it is common that two superconducting wires are arranged in parallel along the helically winding direction and then connected together by soldering or pressure bonding as shown in Fig. 2 (e.g., Patent Document 2). As can be seen from the structure shown in Fig. 2, the connecting portion needs a space corresponding to one turn from an electrical point of view, but it needs a space corresponding to two turns from a physical point of view, thereby causing a local ineffective space corresponding to one turn.

When a metal-based superconducting wire is used, it may often have a round or rectangular cross-section, and therefore, the ineffective space becomes larger, thereby causing a decrease of winding uniformity and a deterioration in the homogeneity of the generated magnetic field. In magnets required to provide magnetic field with very high homogeneity as superconducting magnets for nuclear magnetic resonance (NMR), the ineffective space becomes a crucial problem.

In Patent Document 2 described above, as shown in Fig. 3, a connecting portion as described above is provided outside the winding area, and connection is achieved within a range needing only one spool for winding. Therefore, it causes no problem that an ineffective space is formed between coils connected as shown in Fig. 1. However, oxide superconducting wires have a problem that they are tape-shaped wires having a cross-sectional aspect ratio of about 10 or higher and extremely weak to an edgewise strain, and therefore, their characteristics are significantly reduced by a small strain. When connection giving a large bending strain to the wire is carried out as in the connecting portion shown in Fig. 3, superconducting characteristics are significantly deteriorated. Thus, such a technique cannot be applied to superconducting magnets.

As described above, it is a current condition that no technique has hitherto been established for connecting plural oxide superconducting wires without causing an ineffective space between plural coils and without deteriorating superconducting characteristics in a single coil. In particular, it is a current condition that no method has hitherto been established for producing magnets required to have very high magnetic field homogeneity as NMR superconducting magnets by connecting oxide superconducting wires, because it is very difficult to produce such magnets.

PRIOR ART DOCUMENTS

PATENT DOCUMENTS

Patent Document 1: Japanese Patent Laid-open Publication (Kokai) No. Sho 58-127305
Patent Document 2: Japanese Patent Laid-open Publication (Kokai) No. Sho 59-11603

SUMMARY OF THE INVENTION

PROBLEMS TO BE SOLVED BY THE INVENTION

Under the circumstances described above, the present invention has been completed and its object is to provide oxide superconducting solenoid wound coils in which plural oxide superconducting wires can be connected together without causing an ineffective space between plural coils and without causing a deterioration of superconducting characteristics in a single coil; and useful methods for producing such oxide superconductive solenoid wound coils.

MEANS FOR SOLVING THE PROBLEMS

The oxide superconducting solenoid wound coils of the present invention, which make it possible to solve the above problems, are disclosed as respective oxide superconducting solenoid wound coils according to claims 1 and 3.
In the oxide superconducting solenoid wound coil of embodiments of the present invention, the winding area may preferably have maximum and minimum values of its outer diameter, satisfying a relationship of formula (2) below:

$$(\text{Dmax} - \text{Dmin}) / \text{Dmin} \leq 0.0350 \qquad (2)$$

where Dmax and Dmin are the maximum and minimum values (mm) of the outer diameter in the winding area, respectively; or
the oxide superconducting solenoid wound coil may preferably further comprise an insulation sheet inserted between the oxide superconducting wire layers in the winding area.
When one oxide superconducting solenoid wound coil as described above is produced, there may be employed the steps:

winding one oxide superconducting wire around the cylindrical winding barrel from one end thereof without forming an overlap;
heat-connecting the one oxide superconducting wire and another oxide superconducting wire in a state that a low-melting metal piece is interposed between an upper surface at a winding finish end of the one oxide superconducting wire and a lower surface at a winding start end of the another oxide superconducting wire; and
subsequently winding the another oxide superconducting wire in the same direction as before the connection.

Another oxide superconducting solenoid wound coil exhibiting desired characteristics can be obtained by the steps:

winding one oxide superconducting wire around the cylindrical winding barrel from one end thereof without forming an overlap;
heat-connecting the one oxide superconducting wire and another oxide superconducting wire in a state that a low-melting metal piece is disposed on each of an upper surface at a winding finish end of the one oxide superconducting wire and an upper surface at a winding start end of the another oxide superconducting wire, both of which low-melting metal pieces are bridged with a connecting piece of still another oxide superconducting wire; and
subsequently winding the another oxide superconducting wire in the same winding direction as before the connection.

EFFECT OF THE INVENTION

According to the present invention, it becomes possible to operate solenoid wound coils having homogenous critical current density within the winding area, without deteriorating the superconducting characteristics of oxide superconducting wires, and oxide superconducting solenoid wound coils have been obtained, which are operated in a permanent current mode and are required to have highly precise magnetic filed homogeneity, because plural oxide superconducting wires are connected together by overlaying their wider surfaces one on top of the other, or by arranging the oxide superconducting wires so that their ends are butted against each other and overlapping a wider surface of a tape-shaped connecting piece on wider surfaces of both the oxide superconducting wires, within the multilayer winding area.

BRIEF DESCRIPTION OF THE DRAWINGS

Fig. 1 is a schematic explanatory view showing the connection between coils of metal-based superconducting wires.
Fig. 2 is an explanatory view showing the connection of metal-based superconducting wires within the winding area.
Fig. 3 is a schematic explanatory view showing one embodiment of the connecting portion.
Fig. 4 is a schematic explanatory view showing the structure of the oxide superconducting solenoid wound coil produced in Comparative Example 1.
Fig. 5 is a schematic explanatory view showing the structure of the oxide superconducting solenoid wound coil produced in Example 1.
Fig. 6 is a model view used for the calculation in Example 3.
Fig. 7 is a graph showing the results of calculation in Example 3.
Fig. 8 is a model view used for the calculation in Example 4.
Fig. 9 is a graph showing the results of calculation in Example 4.
Fig. 10 is a schematic explanatory view showing one embodiment of the connecting portion in the present invention.
Fig. 11 is a schematic explanatory view showing another embodiment of the connecting portion in the present invention.

MODE FOR CARRYING OUT THE INVENTION

The present inventors have studied from various angles to solve the above problems. As a result, the present inventors have found that in the case of oxide superconducting wires, the occurrence of an ineffective space in the helical direction can be eliminated to reduce the influence of the ineffective space on the homogeneity of the generated magnetic field, by using a structure in which the wires are connected together by overlaying their wider surfaces one on top of the other, even when the wires are connected together within the winding area, because they are tape-shaped and have a large cross-sectional aspect ratio (ratio of the wire width to the wire thickness). Thus, the present inventors have completed the present invention.

That is, in the case of metal-based superconducting wires, the use of a metal-based superconducting wire having a round or rectangular cross-section causes the local occurrence of an ineffective space to have great influence on the magnetic field homogeneity, if connection is made within the winding area, whereas in the case of oxide superconducting wires, the shape of an ineffective space can be made thin in the coil radius direction and long and uniform in the coil longitudinal direction, thereby making it possible to reduce the influence of the ineffective space on the magnetic field homogeneity.

When oxide superconducting wires are connected together by overlaying their wider surfaces one on top of the other, the overlaid connecting portion may desirably have a length of 50 mm or greater but smaller than one turn. When the connecting portion has a too small length, the connection resistance becomes increased and more heat is generated during the application of a current, resulting in a significant temperature rise. On the other hand, when the connecting portion has a length greater than one turn, the thickness of the solder layer is less uniform to make the magnetic field homogeneity increased.

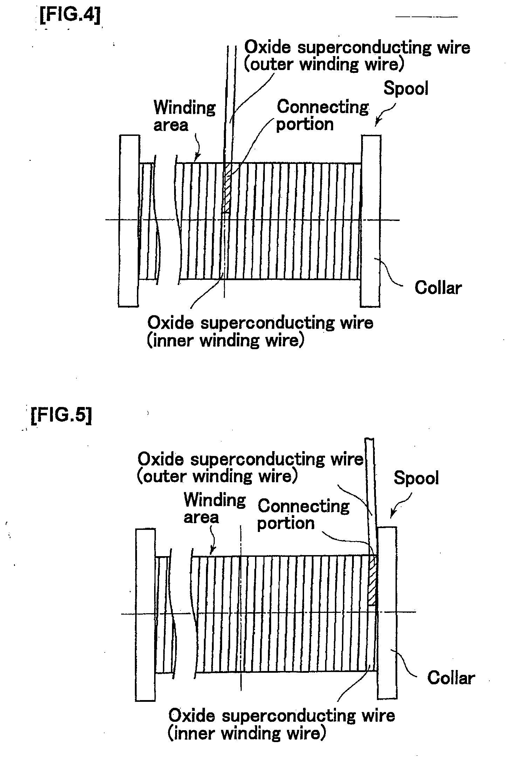

The spool (i.e., both ends of the winding barrel) is provided with collars (see Fig. 4 below). The connecting portion between the oxide superconducting wires may desirably be in the vicinity of one collar where the hoop stress is decreased. According to the studies of the present inventors, when the distance z of the connecting portion from the coil center in the axial direction is shorter than $L/2 - (2.2 \times 10^7/dL)$ where L is the length (mm) in the winding area and d is the inner diameter (mm) in the winding area so that the connecting portion becomes close to the coil center, the hoop stress on the connected wires is increased, resulting in a deterioration of superconducting characteristics. In addition, before the heat generated by the connection resistance is transmitted through the superconducting wires to reach the collars serving as cooling ends, the temperature difference is increased, the temperature at the connection portion becomes too high, and therefore, more refrigerant (coolant) such as liquid helium is evaporated. Furthermore, in extreme cases, the superconducting characteristics of the connecting portion are significantly deteriorated, thereby making it difficult to pass a predetermined current therethrough.

When the connecting portion between the oxide superconducting wires is present at a position satisfying the relationship of formula (1) below:

$$L/2 - (2.2 \times 10^7/dL) \leq |z| < L/2 \qquad (1)$$

where L is the length (mm) of the winding area, d is the inner diameter (mm) of the winding area, and z is the distance (mm) of the connecting portion in the axial direction, provided that the distance is zero at the coil center, the heat generated by the connection resistance can be expected to be released not only in the radius direction but also in the axial direction, even if the connecting portion is present in the vicinity of the winding barrel, thereby making it possible to reduce the temperature rise in the connecting portion within an allowable range.

When the length L (L: the length in the axial direction) of the winding area is decreased, the heat generated in the connecting portion can be expected to be released not only to one collar but also to both collars. Therefore, when L is decreased, the allowable distance of the connecting portion entering in the inside of the winding area away from the collar, [L/2 - (2.2 x 10^7/dL)], becomes greater. In addition, when the inner diameter d of the winding area (d: the diameter of the winding area on the winding barrel side) is decreased, the length of the wires is decreased, even if the length L of the winding area is unchanged. Thus, the heat generated in the connecting portion can efficiently be released to the collars through the wires. Therefore, when d is decreased, the allowable distance of the connecting portion entering in the inside of the winding area away from the collar, [L/2 - (2.2 x 10^7/dL)], becomes greater.

From the viewpoint of homogeneity of the generated magnetic field, important is the uniformity of the winding diameter throughout the winding area including the connecting portion (the outer diameter of the winding area). As is well known (e.g., "Case Studies in Superconducting Magnets," Yukikazu Iwasa (1994), Plenum Press, New York and London), the dependency of magnetic field B on both azimuth angle $\theta$ and elevation angle $\varphi$ in the z direction (z: distance of the connecting portion in the axial direction from the coil center) at a position distant from the central axis in the coil bore by radius r (fixed) is represented by the following expression:

[Math.1]

$$
\begin{aligned}
B_Z(\theta,\phi) &= \sum_{n=0}^{n=\infty}\sum_{m=0}^{m=n} P_{nm}(\cos\theta)\{A_{nm}\cos m\phi + B_{nm}\cos n\phi\} \\
&= P_{00}(\cos\theta)(A_{00}+B_{00}) + P_{10}(\cos\theta)(A_{10}+B_{10}\cos\phi) + P_{11}(\cos\theta)(A_{11}\cos\phi + B_{11}\cos\phi) \\
&\quad + P_{20}(\cos\theta)(A_{20}+B_{20}\cos 2\phi) + \cdots \\
&= (A_{00}+B_{00}) + \cos\theta(A_{10}+B_{10}\cos\phi) + (1-\cos^2\theta)^{\frac{1}{2}}(A_{11}\cos\phi + B_{11}\cos\phi) \\
&\quad + \frac{1}{2}(3\cos^2\theta - 1)(A_{20}+B_{20}\cos 2\phi) + \cdots
\end{aligned}
$$

In the above expression, m and n are integers of 0 or more, and $m \leq n$. In addition, $P_{nm}(\cos\theta)$ is an associated Legendre function. The ratio of $A_{20}$ and $A_{00}$ [$A_{20}/A_{00}$] determined according to the above expression means an inhomogeneity component $(Bz)_2$ in proportion to $(\cos\theta)^2$ (= $z^2$) as an index of inhomogeneity of the z component Bz of the magnetic field.

The present inventors have studied about the influence of the maximum and minimum values of the outer diameter of the winding area on the homogeneity of the generated magnetic field, and it has been found that these values may preferably satisfy the relationship of formula (2) below:

$$(\mathrm{Dmax} - \mathrm{Dmin}) / \mathrm{Dmin} \leq 0.0350 \qquad (2)$$

where Dmax and Dmin are the maximum and minimum values (mm) of the outer diameter in the winding area, respectively.

As the condition for satisfying a relationship of formula (2) above, there can be mentioned inserting an insulation sheet (e.g., polyester sheet) between the oxide superconducting wire layers in the winding area.

When an oxide superconductive solenoid wound coil as described above is produced, the following method may be used, in which one oxide superconducting wire is started to be wound around the cylindrical winding barrel from one end thereof without forming an overlap; the upper surface of the winding finish end of the one oxide superconducting wire and the lower surface of the winding start end of another oxide superconducting wire are heat-connected with a low-melting metal piece being interposed between these surfaces; and the another oxide superconducting wire is subsequently wound in the winding direction before the connection. The use of such a method makes it possible to obtain an oxide superconductive solenoid wound coil with a structure in which the oxide superconducting wires are connected together by overlaying a wider surface of a tape-shaped connecting piece on wider surfaces of both the oxide superconducting wires.

Alternatively, the following method may be used, in which one oxide superconducting wire is started to be wound around the cylindrical winding barrel from one end thereof without forming an overlap; a low-melting metal piece is disposed on each of the upper surface of the winding finish end of the one oxide superconducting wire and the lower surface of the winding start end of another oxide superconducting wire; still another oxide superconducting wire is placed as a connecting piece on these low-melting metal pieces to serve as a bridge, followed by heat connection; and the another oxide superconducting wire is subsequently wound in the same direction as before the connection. The use of such a method makes it possible to obtain an oxide superconducting solenoid wound coil with a structure in which the oxide superconducting wires are connected together by arranging the oxide superconducting wires so that their ends are butted against each other within the multilayer winding area and overlaying a wider surface of a tape-shaped connecting piece on wider surfaces of both the oxide superconducting wires. In particular, this method is effective for making the characteristics of oxide superconducting wires uniform, when the oxide superconducting wires are observed to have characteristic anisotropy on both the wider surfaces of tape-shaped wires as in the case of YBCO (i.e., $YBa_2Cu_3O_x$).

As the low-melting metals that can be used in the methods described above, Ag-containing solders (Sn-Pb-Ag-based solders) are exemplified as a representative example as shown in Examples described later, but as well as Sn-Ag-Cu-based solders and ordinary Sn-Pb-Ag-based solders, low-melting metal materials such as In may also be used. In short, similar effects can be expected by maintaining the temperature of the connecting portion at 250°C or lower.

The kinds of oxide superconducting wires that can be used in the present invention are not particularly limited, but various oxide-based superconducting wires may be used, including, for example, bismuth-based oxide superconducting wires such as Bi-2212 (i.e., $Bi_2Sr_2Ca_1Cu_2O_x$) and Bi-2223 (i.e., $Bi_2Sr_2Ca_2Cu_3O_x$); and YBCO (i.e., $YBa_2Cu_3O_{7-y}$).

EXAMPLES

The following will describe the feature and effect of the present invention more specifically by way of Examples, but the present invention is not limited to the Examples described below. The present invention can be put into practice after appropriate modifications or variations within a range capable of meeting the gist described above and below, all of which are included in the technical scope of the present invention.

[Comparative Example 1]

An insulating polyimide tape of 0.025 mm in thickness was wound around an oxide superconducting wire of $Bi_2Sr_2Ca_2Cu_3O_x$. (Bi-2223) with a section size of 0.36 mm x 4.45 mm and a sandwich structure having two brass tapes as a reinforcement material on both sides to give a polyimide coated and insulated oxide superconducting wire (internal winding wire) of 0.41 mm in thickness and 4.50 mm in width. This wire was wound in solenoid form around a stainless steel winding barrel of 78.4 mm in diameter and 840 mm in length to form a wire winding area, the structure of which is shown in Fig. 4 (schematic explanatory view).

As shown in Fig. 4, the oxide superconducting wire was wound in all 25 layers around a spool, starting from one collar of the spool, and when the oxide superconducting wire was tuned at the other collar on the opposite side and further wound to the position of z = 0 mm (the reference position of z in the tape is the center of the spool in the axial direction where z = 0), the other end of the oxide superconducting wire came to that position. The surface of a wire portion corresponding to the length of 80 mm from the other end was coated with an Ag-containing solder (Sn-Pb-Ag-based solder). An end of a Bi-2223 oxide superconducting wire (outer winding wire) wound beforehand around another spool was drawn out, and the surface of a wire portion of 80 mm in length from the other end was coated with the same Ag-containing solder as described above.

As shown in Fig. 4, the solder-coated surface of the outer winding wire was overlaid on the solder-coated surface of the inner winding wire, both of which were pressed by a soldering iron with a head kept at a temperature of 280°C to melt the solder, thereby connecting the inner winding wire and the outer winding wire [since L = 840 mm and d = 78.4 mm, L/2 - (2.2 x $10^7$/dL) = 85.9 mm > |z| = 0 mm]. A thin-film temperature sensor was attached to the surface of the connecting portion, and the outer winding wire was subsequently wound in a total of 54 layers.

After the winding, the coil was entirely impregnated with wax. The impregnated coil was placed in a cryostat of 54 mm in bore diameter at room temperature, and liquid helium was fed into the cryostat. Then, a current of 245 A was applied thereto. As a result, the connecting portion had a temperature of 4.7 K just after the initiation of the current application, but the temperature rose over time, and the occurrence of blowout was found in the connecting portion after 30 minutes.

[Example 1]

Similarly to Comparative Example 1, the oxide superconducting wire (inner winding wire) was wound in all 26 layers around a spool, starting from one collar of the spool, and the other end of the oxide superconducting wire came to the position of z = 418 mm. The surface of a wire portion corresponding to the length of 80 mm from the other end was coated with an Ag-containing solder (Sn-Pb-Ag-based solder). An end of a Bi-2223 oxide superconducting wire (outer winding wire) wound beforehand around another spool was drawn out, and the surface of a wire portion of 80 mm in length from the end was coated with the same Ag-containing solder as described above, the structure of which is shown in Fig. 5 (schematic explanatory view).

As shown in Fig. 5, the solder-coated surface of the outer winding wire was overlaid on the solder-coated surface of the inner winding wire, both of which were pressed by a soldering iron with a head kept at a temperature of 280°C for melting the solder to connect the inner winding wire and the outer winding wire [since L = 840 mm and d = 78.4 mm, $L/2 - (2.2 \times 10^7/dL) = 85.9$ mm $< |z| = 418$ mm $< L/2 = 420$ mm]. A thin-film temperature sensor was attached to the surface of the connecting portion, and the outer winding wire was subsequently wound in a total of 54 layers.

After the winding, the coil was entirely impregnated with wax. The impregnated coil was placed in a cryostat of 54 mm in bore diameter at room temperature, and liquid helium was fed into the cryostat. Then, a current of 245 A was applied thereto. As a result, the connecting portion had a temperature of 4.7 K just after the initiation of the current application, and even when continuous operation was carried out for 2 hours, the connecting portion did not cause a temperature rise to keep a constant temperature.

[Example 2]

Similarly to Comparative Example 1, the oxide superconducting wire (inner winding wire) was wound in all 25 layers around a spool, starting from one collar of the spool, and when the oxide superconducting wire was turned at the other collar on the opposite side and further wound to the position of z = -100 mm, the other end of the oxide superconducting wire came to that position. Then, similarly to Example 1, the inner winding wire and the outer winding wire were connected together [L = 840 mm and d = 78.4 mm, and therefore, $L/2 - (2.2 \times 10^7/dL) = 85.9$ mm $< |z| = 100$ mm $< L/2 = 420$ mm]. A thin-film temperature sensor was attached to the surface of the connecting portion, and the outer winding wire was subsequently wound in a total of 54 layers.

After the winding, the coil was entirely impregnated with wax. The impregnated coil was placed in a cryostat of 54 mm in bore diameter at room temperature, and liquid helium was fed into the cryostat. Then, a current of 245 A was applied thereto. As a result, the connecting portion had a temperature of 4.7 K just after the initiation of the current application, and even when continuous operation was carried out for 2 hours, the connecting portion did not cause a temperature rise to keep a constant temperature.

[Example 3]

Assuming that oxide superconducting coils each having a connecting portion at the position of z = -100 mm were produced similarly to Example 2, $(Bz)_2 = A_{20}/A_{00}$ was calculated, which is obtained when a current of 245 A is applied and means the $z^2$ component of magnetic field inhomogeneity in a spherical space of 20 mm in diameter at the center of the magnet bore.

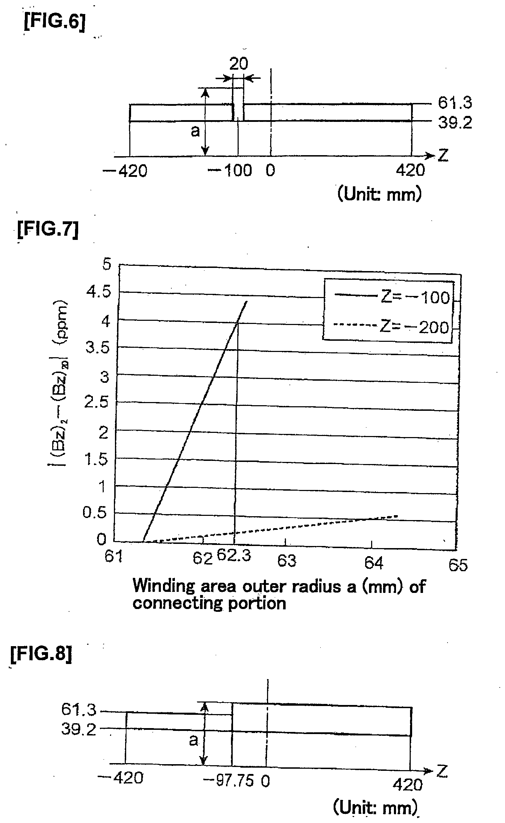

In this calculation, a model as shown in Fig. 6 (model view) is used, in which the winding area of 39.2 mm in inner radius and 61.3 mm in outer radius as a base was replaced by the connection at the position of z = -100 mm with a winding area having an outer radius increased to a mm in the width of 20 mm with the connecting portion being taken as the center. The winding layer number was constant as 54 at any z position. The value of the outer radius a of the connecting portion and $(Bz)_2 = A_{20}/A_{00}$ as the $z^2$ component were calculated, and the difference $[(Bz)_2 - (Bz)_{20}]$ (ppm) from $(Bz)_2$ (= $(Bz)_{20}$) when a = 61.3 mm was determined. The results are shown in Fig. 7, together with the results obtained in the case of connection at the position of z = -200 mm. As can be seen from these results, it is found that $(Bz)_2 - (Bz)_{20}$ increases with an increase in the outer radius a of the connecting portion, resulting in a lowering of magnetic field homogeneity.

In commercially available NMR superconducting magnets, magnetic field homogeneity is adjusted by magnetic field homogeneity adjustment coils called as shim coils. However, the adjustable range is limited, and therefore, $[(Bz)_2 - (Bz)_{20}]$ is required to be adjusted within a range of about $\pm 4$ ppm before the adjustment of the shim coils.

From the results shown in Fig. 7, a < 62.4 mm is required to satisfy $(Bz)_2 - (Bz)_{20} \leq 4$ ppm. When the maximum and minimum values of the outer diameter in the winding area are expressed by Dmax and Dmin, respectively, Dmax = 62.4 mm x 2 = 124.8 mm, Dmin = 61.3 mm x 2 = 122.6 mm, and therefore, (Dmax - Dmin) / Dmin = 0.0179 ($\leq$ 0.0350).

That is, in Example 1 above, continuous operation was possible in the case of the superconducting magnet having the connection within the winding area, but it needs to satisfy the relationship represented by expression (2) above when the generated magnetic field is required to have high homogeneity as in NMR magnets.

When the position of connection is closer to the collar, it results in that the restriction due to (Dmax - Dmin) / Dmin is more reduced. Fig. 7 also shows the relationship between the winding area outer radius a of the connecting portion and $(Bz)_2$ - $(Bz)_{20}$ in the case where the connecting portion is present at the position of z = -200 mm. The value of $(Bz)_2$ - $(Bz)_{20}$ in the case of z = -200 mm was able to be held smaller than that in the case of z = -100 mm when compared for the winding area outer radius of the same connecting portion.

[Example 4]

Similarly to Example 2, the oxide superconducting wire (inner winding wire) was wound in all 25 layers around a spool, starting from one collar of the spool, and when the oxide superconducting wire was turned at the other collar on the opposite side and further wound to the position of z = -100 mm, the other end of the oxide superconducting wire came to that position. Then, similarly to Comparative Example 1, the inner winding wire and the outer winding wire were connected together [L = 840 mm and d = 78.4 mm, and therefore, L/2 - (2.2 x $10^7$/dL) = 85.9 mm < |z| = 100 mm < L/2 = 420 mm].

Then, a thin-film temperature sensor was attached to the surface of the connecting portion, and a polyester film sheet of 0.50 mm in thickness (trade name: "Mylar" available from Du Pont) was wound around the surface of the winding area in the region of -97.75 mm < z < 420 mm, and an outer winding wire was subsequently wound thereon in a total of 54 layers. After the winding, the coil was entirely impregnated with wax. The impregnated coil was placed in a cryostat of 54 mm in bore diameter at room temperature, and liquid helium was fed into the cryostat. Then, a current of 245 A was applied thereto. As a result, the connecting portion had a temperature of 4.4 K just after the initiation of the current application, which became 0.2 K higher than 4.2 K as the liquid helium temperature, but even when continuous operation was carried out for 2 hours, the connecting portion did not cause a temperature rise to keep a constant temperature.

Assuming that oxide superconducting coils each having a connecting portion at the position of z = -100 mm as in the case of the coil described above were produced by attaching no temperature sensor to each connecting portion, winding polyester film sheets having different thicknesses (trade name: "Mylar" available from Du Pont) around the surface of each winding area in the region of -97.75 mm < z < 420 mm, and subsequently winding an outer winding wire thereon each in a total of 54 layers, $(Bz)_2$ = $A_{20}/A_{00}$ was calculated, which is obtained when a current of 245 A is applied and means the $z^2$ component of magnetic field inhomogeneity in a spherical space of 20 mm in diameter at the center of the magnet bore.

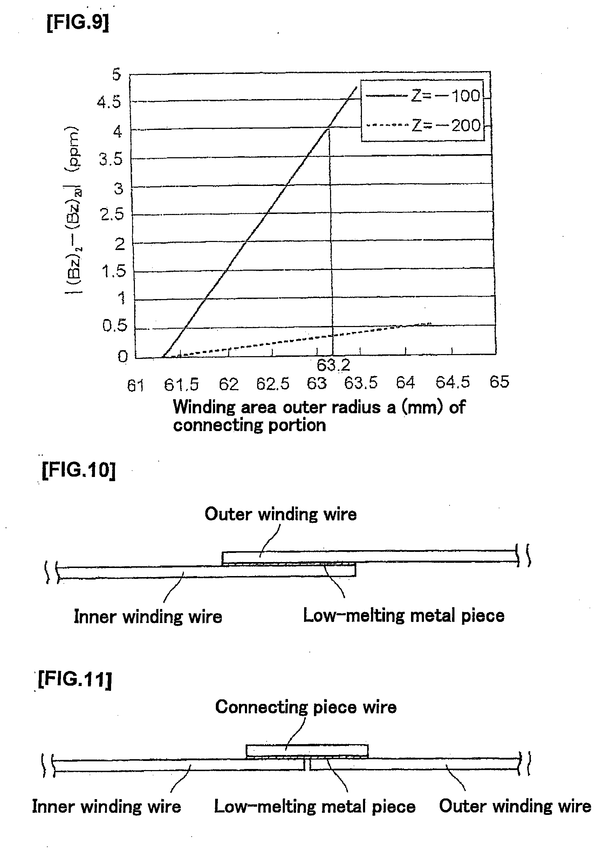

In this calculation, as shown in Fig. 8 (model view), a model is used, in which the winding area of 39.2 mm in inner radius and 61.3 mm in outer radius as a base was replaced with a winding area having an outer radius changed to a mm in the region where a sheet of -97.75 mm < z < 420 mm was inserted. The winding layer number was constant as 54 at any z position. $(Bz)_2$ = $A_{20}/A_{00}$ as the $z^2$ component was calculated, and the absolute value of the difference $|(Bz)_2$ - $(Bz)_{20}|$ (ppm) from $(Bz)_2$ (= $(Bz)_{20}$) when a = 61.3 mm was determined. The results are shown in Fig. 9, together with the results obtained in the case of connection at the position of z = -200 mm. As can be seen from these results, it is found that $(Bz)_2$ - $(Bz)_{20}$ increases with an increase in the outer radius a of the connecting portion, resulting in a lowering of magnetic field homogeneity.

From the results shown in Fig. 9, a < 63.2 mm is required to satisfy $(Bz)_2$ - $(Bz)_{20} \leq 4$ ppm. When the maximum and minimum values of the outer diameter in the winding area are expressed by Dmax and Dmin, respectively, Dmax = 63.2 mm x 2 = 126.4 mm, Dmin = 61.3 mm x 2 = 122.6 mm, and therefore, (Dmax - Dmin) / Dmin = 0.0310 ($\leq$ 0.0350).

That is, (Dmax - Dmin) / Dmin $\leq$ 0.0179 is required to satisfy $|(Bz)_2$ - $(Bz)_{20}| \leq 4$ ppm in Example 3, whereas (Dmax - Dmin) / Dmin $\leq$ 0.0310 is only required in Example 4, which indicates that winding restrictions are reduced in the latter.

When the position of connection is closer to the collar, it results in that the restriction due to (Dmax - Dmin) / Dmin is more reduced. Fig. 9 also shows the relationship between the winding area outer radius a of the sheet-inserted portion and $(Bz)_2$ - $(Bz)_{20}$ in the case where the connecting portion is present at the position of z = -200 mm. The value of $(Bz)_2$ - $(Bz)_{20}$ in the case of z = -200 mm was able to be held smaller than that in the case of z = -100 mm when compared for the winding area outer radius of the same connecting portion.

In Examples 3 and 4, the outer radius of the winding area was assumed for the calculation. For an actual coil, however, it is desirable that the minimum and maximum values of the diameter of the winding area are determined by measuring the values at at least five points, including the connecting portion, at regular intervals in the longitudinal direction of the winding area.

In the Examples described above, there were shown the cases where the winding area contains one connecting portion, but similar effects can also be expected, even in the cases where the winding area contains plural connecting portions, and therefore, these cases can be applied to the present invention.

For the length L and inner diameter d of the winding area, it is necessary to satisfy L/2 - (2.2 $\times$ $10^7$/dL) $\geq$ 0, and therefore, it is necessary to satisfy $dL^2 \geq 4.4 \times 10^7$. The upper limits of L and d are not particularly limited, but when these values are increased, the allowable distance (2.2 x $10^7$/dL) of the connecting portion entering in the inside of the winding area away from the collar becomes closer to zero, which means to permit the connection to be only at a position adjacent to the collar.

In the Examples described above, a connection method was used, in which the connecting portion has a cross-section as shown in Fig. 10, but similar effects can also be expected, even when a connection method is used, in which the connecting portion has a cross-section as shown in Fig. 11. More specifically, in the connection method as shown in Fig. 10, one oxide superconducting wire is started to be wound around the cylindrical winding barrel from one end thereof forming an overlap; the upper surface (wider surface) of the winding finish end of the one oxide superconducting wire and the lower surface (wider surface) of one end of another oxide superconducting wire are heat-connected with a low-melting metal piece being interposed between these surfaces; and the another oxide superconducting wire is subsequently wound in the same direction as before the connection; however, the connection method as shown in Fig. 11 may also be applied, i.e., one oxide superconducting wire is started to be wound around the cylindrical winding barrel from one end thereof without forming an overlap; a low-melting metal piece is disposed on each of the upper surface (wider surface) of the winding finish end of the one oxide superconducting wire and the lower surface (wider surface) of the winding start end of another oxide superconducting wire; still another oxide superconducting wire is placed as a connecting piece on these low-melting metal pieces to serve as a bridge, followed by heat connection; and the another oxide superconducting wire is subsequently wound in the same direction as before the connection.

In particular, when a YBCO-based superconducting wire is used, an intermediate layer is formed on a Hastelloy or Ni-W substrate, and a YBCO-based superconducting wire (thin film) is formed thereon. In some cases, therefore, the cross sectional structure of the wire is asymmetric in the vertical direction (i.e., a tape-shaped wire has a characteristic anisotropy between both wider surfaces). In such cases, favorable connection can be achieved, in Fig. 11, by arranging the Hastelloy or Ni-W substrates so that they face in opposite directions in the cross sectional structure of the connecting portion and by arranging the wires so that the YBCO-based superconducting wires in the inner winding wire and in the connecting piece (connecting piece wire) face each other, and the YBCO-based superconducting wires in the outer winding wire and in the connecting piece wire (connecting piece) face each other.

INDUSTRIAL APPLICABILITY

The oxide superconducting solenoid wound coils of the present invention have a structure in which the oxide superconducting wires are connected together by overlaying their wider surfaces one on top of the other within the multilayer winding area or in which the oxide superconducting wires are connected together by arranging the oxide superconducting wires so that their ends are butted against each other and overlaying a wider surface of a tape-shaped connecting piece on wider surfaces of both the oxide superconducting wires within the multilayer winding area; with the use of such a structure, plural oxide superconducting wires can be connected without causing an ineffective space between plural coils and without causing a deterioration of superconducting characteristics in a single coil.

**Claims**

1. An oxide superconducting solenoid wound coil comprising:

   plural tape-shaped oxide superconducting wires electrically connected in series and helically wound in multiple layers around a cylindrical winding barrel of a spool, thus forming a multilayer winding area, wherein the multilayer winding area is the area of the spool on which the superconducting wires are wound in multiple layers,
   wherein the oxide superconducting wires are connected together by overlaying their wider surfaces one on top of the other within the multilayer winding area, and
   wherein the oxide superconducting wires have a connecting portion at a position satisfying a relationship of formula (1) below:

   $$L/2 - (2.2 \text{ x } 10^7/dL) \leq |z| < L/2 \qquad (1)$$

   where L is the length in mm of the multilayer winding area in the axial direction of the spool, d is the inner diameter in mm of the multilayer winding area, and z is the distance in mm from the centre of the coil in an axial direction.

2. The oxide superconducting solenoid wound coil according to claim 1, further comprising an insulation sheet inserted between the oxide superconducting wire layers in the multilayer winding area.

3. An oxide superconducting solenoid wound coil comprising:

plural tape-shaped oxide superconducting wires electrically connected in series and helically wound in multiple layers around a cylindrical winding barrel of a spool thus forming a multilayer winding area, wherein the multilayer winding area is the area of the spool on which the superconducting wires are wound in multiple layers, wherein the oxide superconducting wires are connected together by arranging the oxide superconducting wires so that their ends are butted against each other and overlaying a wider surface of a tape-shaped connecting piece on wider surfaces of both the oxide superconducting wires within the multilayer winding area, and wherein the oxide superconducting wires have a connecting portion at a position satisfying a relationship of formula (1) below:

$$L/2 - (2.2 \times 10^7/dL) \leq |z| < L/2 \qquad (1)$$

where L is the length in mm of the multilayer winding area in the axial direction, d is the inner diameter in mm of the multilayer winding area, and z is the distance in mm from the centre of the coil in an axial direction.

4. The oxide superconducting solenoid wound coil according to claim 3, further comprising an insulation sheet inserted between the oxide superconducting wire layers in the multilayer winding area.

5. The oxide superconducting solenoid wound coil according to any one of claims 1 to 4, wherein the multilayer winding area has maximum and minimum values of its outer diameter, satisfying a relationship of formula (2) below:

$$(D_{max} - D_{min}) / D_{min} \leq 0.0350 \qquad (2)$$

where Dmax and Dmin are the maximum and minimum values of the outer diameter in the multilayer winding area, respectively.

**Patentansprüche**

1. Zylinderspule mit einem Oxid-Supraleitermagneten, umfassend:

mehrere bandförmige Oxid-Supraleiterdrähte, die elektrisch in Reihe verbunden und in mehreren Schichten spiralförmig um eine zylindrische Wickeltrommel einer Spule gewickelt sind, wodurch ein mehrschichtiger Wicklungsbereich gebildet ist, wobei der mehrschichtige Wicklungsbereich der Bereich der Spule ist, auf den die Supraleiterdrähte in mehreren Schichten gewickelt sind, wobei die Oxid-Supraleiterdrähte miteinander verbunden sind durch Übereinanderlegen ihrer breiteren Oberflächen innerhalb des mehrschichtigen Wicklungsbereichs, und wobei die Oxid-Supraleiterdrähte einen Verbindungsabschnitt an einer Position aufweisen, die eine Beziehung der nachstehenden Formel (1) erfüllt:

$$L/2 - (2.2 \times 10^7/dL) \leq |z| < L/2 \qquad (1)$$

wobei L die Länge des mehrschichtigen Wicklungsbereiches in mm in der axialen Richtung der Spule ist, d der Innendurchmesser des mehrschichtigen Wicklungsbereiches in mm ist und z der Abstand in mm von der Mitte der Spule in einer axialen Richtung ist.

2. Zylinderspule mit einem Oxid-Supraleitermagneten nach Anspruch 1, weiter umfassend ein Isolationsblatt, das zwischen den Schichten des Oxid-Supraleiterdrahtes im mehrschichtigen Wicklungsbereich eingefügt ist.

3. Zylinderspule mit einem Oxid-Supraleitermagneten, umfassend: mehrere bandförmige Oxid-Supraleiterdrähte, die elektrisch in Reihe verbunden und in mehreren Schichten spiralförmig um eine zylindrische Wickeltrommel einer Spule gewickelt sind, wodurch ein mehrschichtiger Wicklungsbereich gebildet ist, wobei der mehrschichtige Wicklungsbereich der Bereich der Spule ist, auf den die Supraleiterdrähte in mehreren Schichten gewickelt sind, wobei die Oxid-Supraleiterdrähte miteinander verbunden sind, indem die Oxid-Supraleiterdrähte so angeordnet sind, dass ihre Enden aneinander stoßen und eine breitere Oberfläche eines bandförmigen Verbindungsstücks auf breiteren Oberflächen der beiden Oxid-Supraleiterdrähte innerhalb des mehrschichtigen Wicklungsbereichs überlagern, und
wobei die Oxid-Supraleiterdrähte einen Verbindungsabschnitt an einer Position aufweisen, die eine Beziehung der nachstehenden Formel (1) erfüllt:

$$L/2 - (2.2 \times 10^7/dL) \leq |z| < L/2 \qquad (1)$$

wobei L die Länge des mehrschichtigen Wicklungsbereiches in mm in der axialen Richtung ist, d der Innendurchmesser des mehrschichtigen Wicklungsbereiches in mm ist und z der Abstand in mm von der Mitte der Spule in einer axialen Richtung ist.

4. Zylinderspule mit einem Oxid-Supraleitermagneten nach Anspruch 3, weiter umfassend ein Isolationsblatt, das zwischen den Schichten des Oxid-Supraleiterdrahtes im mehrschichtigen Wicklungsbereich eingefügt ist.

5. Zylinderspule mit einem Oxid-Supraleitermagneten nach einem der Ansprüche 1 bis 4, wobei der mehrschichtige Wicklungsbereich maximale und minimale Werte seines Außendurchmessers aufweist, die eine Beziehung der nachstehenden Formel (2) erfüllen:

$$(Dmax - Dmin) / Dmin \leq 0.0350 \qquad (2)$$

wobei Dmax beziehungsweise Dmin jeweils die maximalen beziehungsweise minimalen Werte des Außendurchmessers im mehrschichtigen Wicklungsbereich sind.

## Revendications

1. Bobine supraconductrice à oxyde enroulée en solénoïde comprenant :

une pluralité de fils supraconducteurs à oxyde en forme de ruban connectés électriquement en série et enroulés de manière hélicoïdale en de multiples couches autour d'un corps d'enroulement cylindrique d'un tambour, formant ainsi une zone d'enroulement multicouches, dans laquelle la zone d'enroulement multicouches est la zone du tambour sur laquelle les fils supraconducteurs sont enroulés en de multiples couches,
dans laquelle les fils supraconducteurs à oxyde sont connectés ensemble en superposant leurs surfaces plus larges l'une au-dessus de l'autre au sein de la zone d'enroulement multicouches,
et
dans laquelle les fils supraconducteurs à oxyde ont une portion de connexion à une position satisfaisant une relation de la formule (1) ci-dessous :

$$L/2 - (2.2 \times 10^7/dL) \leq |z| < L/2 \qquad (1)$$

où L est la longueur en mm de la zone d'enroulement multicouches dans la direction axiale du tambour, d est le diamètre interne en mm de la zone d'enroulement multicouches et z est la distance en mm depuis le centre de la bobine dans une direction axiale.

2. Bobine supraconductrice à oxyde enroulée en solénoïde selon la revendication 1, comprenant en outre une feuille isolante insérée entre les couches de fil supraconducteur à oxyde dans la zone d'enroulement multicouches.

3. Bobine supraconductrice à oxyde enroulée en solénoïde comprenant :

une pluralité de fils supraconducteurs à oxyde en forme de ruban connectés électriquement en série et enroulés de manière hélicoïdale en de multiples couches autour d'un corps d'enroulement cylindrique d'un tambour, formant ainsi une zone d'enroulement multicouches, dans laquelle la zone d'enroulement multicouches est la zone du tambour sur laquelle les fils supraconducteurs sont enroulés en de multiples couches,

dans laquelle les fils supraconducteurs à oxyde sont connectés ensemble en agençant les fils supraconducteurs à oxyde de sorte que leurs extrémités butent l'une contre l'autre et superposant une surface plus large d'une pièce de connexion en forme de ruban sur des surfaces plus larges des deux fils supraconducteurs à oxyde au sein de la zone d'enroulement multicouches,

et

dans laquelle les fils supraconducteurs à oxyde ont une portion de connexion à une position satisfaisant une relation de la formule (1) ci-dessous :

$$L/2 - (2.2 \times 10^{7}/dL) \leq |z| < L/2 \qquad (1)$$

où L est la longueur en mm de la zone d'enroulement multicouches dans la direction axiale, d est le diamètre interne en mm de la zone d'enroulement multicouches et z est la distance en mm depuis le centre de la bobine dans une direction axiale.

4. Bobine supraconductrice à oxyde enroulée en solénoïde selon la revendication 3, comprenant en outre une feuille isolante insérée entre les couches de fil supraconducteur à oxyde dans la zone d'enroulement multicouches.

5. Bobine supraconductrice à oxyde enroulée en solénoïde selon l'une quelconque des revendications 1 à 4, dans laquelle la zone d'enroulement multicouches a des valeurs maximale et minimale de son diamètre externe, satisfaisant une relation de la formule (2) ci-dessous :

$$(Dmax - Dmin) / Dmin \leq 0{,}0350 \qquad (2)$$

où Dmax et Dmin sont les valeurs maximale et minimale du diamètre externe dans la zone d'enroulement multicouches, respectivement.

[FIG.1]

NbTi coil     Nb$_3$Sn coil

[FIG.2]

Superconducting wire

[FIG.3]

Winding area

Connecting portion

[FIG.4]

Oxide superconducting wire
(outer winding wire)

Spool

Winding area

Connecting portion

Collar

Oxide superconducting wire
(inner winding wire)

[FIG.5]

Oxide superconducting wire
(outer winding wire)

Spool

Winding area   Connecting portion

Collar

Oxide superconducting wire
(inner winding wire)

[FIG.6]

(Unit: mm)

[FIG.7]

Winding area outer radius a (mm) of connecting portion

[FIG.8]

(Unit: mm)

[FIG.9]

Winding area outer radius a (mm) of
connecting portion

[FIG.10]

Outer winding wire

Inner winding wire     Low-melting metal piece

[FIG.11]

Connecting piece wire

Inner winding wire     Low-melting metal piece     Outer winding wire

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP SHO58127305 B

- JP SHO5911603 B

**Non-patent literature cited in the description**

- Case Studies in Superconducting Magnets. Yukikazu Iwasa. Plenum Press, 1994